# EUROPÄISCHE PATENTSCHRIFT

(11) **EP 3 372 883 B1**
(45) Veröffentlichungstag und Bekanntmachung des Hinweises auf die Patenterteilung: **11.12.2019**
(21) Anmeldenummer: 17160094.3
(22) Anmeldetag: 09.03.2017
(51) Int. Cl.: F16K 51/02, F16K 37/00, F16K 3/10, F16K 3/18, G01B 11/00

(54) **VAKUUMVENTIL MIT OPTISCHEM SENSOR**
VACUUM VALVE WITH OPTICAL SENSOR
VANNE DE CONTRÔLE DE VIDE COMPRENANT UN CAPTEUR OPTIQUE

(43) Veröffentlichungstag der Anmeldung: 12.09.2018
(73) Patentinhaber: VAT Holding AG, 9469 Haag (CH)
(72) Erfinder: HOFER, Andreas, 9443 Widnau (CH); BÖHM, Christoph, 9473 Gams (CH); ESCHENMOSER, Adrian, 9472 Grabs (CH)
(74) Vertreter: Kaminski Harmann

(56) Entgegenhaltungen:
- WO-A1-2012/096618
- DE-A1-102007 034 927
- DE-A1-102014 008 170
- KR-B1- 101 410 793

## Beschreibung

Die Erfindung betrifft ein System aus einem Vakuumventil und einer optischen Sensoreinheit.

Allgemein sind Vakuumventile zur Regelung eines Volumen- oder Massenstroms und zum im Wesentlichen gasdichten Schliessen eines Fliesswegs, der durch eine in einem Ventilgehäuse ausgeformte Öffnung führt, in unterschiedlichen Ausführungsformen aus dem Stand der Technik bekannt und kommen insbesondere bei Vakuumkammersystemen im Bereich der IC-, Halbleiter- oder Substratfertigung, die in einer geschützten Atmosphäre möglichst ohne das Vorhandensein verunreinigender Partikel stattfinden muss, zum Einsatz. Derartige Vakuumkammersysteme umfassen insbesondere mindestens eine zur Aufnahme von zu bearbeitenden oder herzustellenden Halbleiterelementen oder Substraten vorgesehene, evakuierbare Vakuumkammer, die mindestens eine Vakuumkammeröffnung besitzt, durch welche die Halbleiterelemente oder anderen Substrate in die und aus der Vakuumkammer führbar sind, sowie mindestens eine Vakuumpumpe zum Evakuieren der Vakuumkammer. Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozess-Vakuumkammern, in denen die innerhalb der Prozess-Vakuumkammern befindlichen Teile mittels jeweils einer Bearbeitungsvorrichtung bearbeitet werden. Sowohl während des Bearbeitungsprozesses innerhalb der Prozess-Vakuumkammern, als auch während des Transports von Kammer zu Kammer müssen sich die hochsensiblen Halbleiterelemente oder Substrate stets in geschützter Atmosphäre - insbesondere in luftleerer Umgebung - befinden.

Hierfür kommen zum einen Peripherieventile zum Öffnen und Schliessen einer Gaszu- oder -abfuhr und zum anderen Transferventile zum Öffnen und Schliessen der Transferöffnungen der Vakuumkammern für das Ein- und Ausführen der Teile zum Einsatz.

Die von Halbleiterteilen durchlaufenen Vakuumventile werden aufgrund des beschriebenen Anwendungsgebiets und der damit verbundenen Dimensionierung als Vakuum-Transferventile, aufgrund ihres mehrheitlich rechteckigen Öffnungsquerschnitts auch als Rechteckventil und aufgrund ihrer üblichen Funktionsweise auch als Schieberventil, Rechteckschieber oder Transferschieberventil bezeichnet.

Peripherieventile werden insbesondere zur Steuerung oder Regelung des Gasflusses zwischen einer Vakuumkammer und einer Vakuumpumpe oder einer weiteren Vakuumkammer eingesetzt. Peripherieventile befinden sich beispielsweise innerhalb eines Rohrsystems zwischen einer Prozess-Vakuumkammer oder einer Transferkammer und einer Vakuumpumpe, der Atmosphäre oder einer weiteren Prozess-Vakuumkammer. Der Öffnungsquerschnitt derartiger Ventile, auch Pumpenventile genannt, ist in der Regel kleiner als bei einem Vakuum-Transferventil. Da Peripherieventile abhängig vom Einsatzgebiet nicht nur zum vollständigen Öffnen und Schliessen einer Öffnung, sondern auch zum Steuern oder Regeln eines Durchflusses durch kontinuierliches Verstellen des Öffnungsquerschnitts zwischen eine vollständigen Offenstellung und einer gasdichten Geschlossenstellung eingesetzt werden, werden sie auch als Regelventile bezeichnet. Ein mögliches Peripherieventil zur Steuerung oder Regelung des Gasflusses ist das Pendelventil.

Bei einem typischen Pendelventil, wie beispielsweise aus der KR101410793B1 (DREAMSOL) oder der US 6,089,537 (Olmsted) bekannt, wird in einem ersten Schritt ein in der Regel runder Ventilteller über eine in der Regel ebenfalls runde Öffnung von einer die Öffnung freigebenden Stellung in eine die Öffnung überdeckende Zwischenstellung rotatorisch geschwenkt. Im Falle eines Schieberventils, wie beispielsweise in der US 6,416,037 (Geiser) oder der US 6,056,266 (Blecha) beschrieben, ist der Ventilteller, wie auch die Öffnung, meist rechteckig ausgebildet und wird in diesem ersten Schritt linear von einer die Öffnung freigebenden Stellung in eine die Öffnung überdeckende Zwischenstellung geschoben. In dieser Zwischenstellung befindet sich der Ventilteller des Pendel- oder Schieberventils in einer beabstandeten Gegenüberlage zu dem die Öffnung umgebenden Ventilsitz. In einem zweiten Schritt wird der Abstand zwischen dem Ventilteller und dem Ventilsitz verkleinert, so dass der Ventilteller und der Ventilsitz gleichmässig aufeinander gedrückt werden und die Öffnung im Wesentlichen gasdicht verschlossen wird. Diese zweite Bewegung erfolgt vorzugsweise im Wesentlichen in eine senkrechte Richtung zum Ventilsitz. Die Abdichtung kann z.B. entweder über einen auf der Verschlussseite des Ventiltellers angeordneten Dichtungsring, der auf den die Öffnung umlaufenden Ventilsitz gepresst wird, erfolgen, oder über einen Dichtungsring auf dem Ventilsitz, gegen den die Verschlussseite des Ventiltellers gedrückt wird. Durch den in zwei Schritten erfolgenden Schliessvorgang wird der Abdichtring zwischen dem Ventilteller und dem Ventilsitz kaum Scherkräften, die den Abdichtring zerstören würden, unterworfen, da die Bewegung des Ventiltellers im zweiten Schritt im Wesentlichen geradlinig senkrecht auf den Ventilsitz stattfindet.

Unterschiedliche Dichtvorrichtungen sind aus dem Stand der Technik bekannt, beispielsweise aus der US 6,629,682 B2 (Duelli). Ein geeignetes Material für Dichtungsringe und Dichtungen bei Vakuumventilen ist beispielsweise Fluorkautschuk, auch FKM genannt, insbesondere das unter dem Handelsnamen "Viton" bekannte Fluorelastomer, sowie Perfluorkautschuk, kurz FFKM.

Aus dem Stand der Technik sind unterschiedliche Antriebssysteme zur Erzielung diese Kombination einer beim Pendelventil rotatorischen und beim Schieberventil translatorischen Bewegung des Ventiltellers parallel über die Öffnung und einer im Wesentlichen translatorischen Bewegung senkrecht auf die Öffnung bekannt, beispielsweise aus der US 6,089,537 (Olmsted) für ein Pendelventil und aus der US 6,416,037 (Geiser) für ein Schieberventil.

Das Anpressen des Ventiltellers auf den Ventilsitz muss derart erfolgen, dass sowohl die geforderte Gasdichtigkeit innerhalb des gesamten Druckbereichs sichergestellt ist, als auch eine Beschädigung des Abdichtmediums, insbesondere des Abdichtrings in Form eines O-Rings, durch zu grosse Druckbeanspruchung vermieden wird. Um dies zu gewährleisten, sehen bekannte Ventile eine in Abhängigkeit von der zwischen den beiden Ventiltellerseiten herrschenden Druckdifferenz geregelte Anpressdruckregelung des Ventiltellers vor. Besonders bei grossen Druckschwankungen oder dem Wechsel von Unterdruck auf Überdruck, oder umgekehrt, ist eine gleichmässige Kraftverteilung entlang des gesamten Umfangs des Abdichtrings jedoch nicht immer gewährleistbar. Generell wird angestrebt, den Abdichtring von Abstützkräften, die sich aus dem an das Ventil anliegenden Druck ergeben, zu entkoppeln. In der US 6,629,682 (Duelli) wird hierzu z.B. ein Vakuumventil mit einem Abdichtmedium vorgeschlagen, das sich aus einem Abdichtring und einem danebenliegenden Abstützring zusammensetzt, so dass der Abdichtring von Abstützkräften im Wesentlichen befreit ist.

Um die geforderte Gasdichtigkeit, gegebenenfalls sowohl für Über- als auch Unterdruck, zu erreichen, sehen zusätzlich oder alternativ zum zweiten Bewegungsschritt manche bekannte Pendelventile oder Schieberventile einen senkrecht zum Ventilteller verschiebbaren, die Öffnung umgebenden Ventilring vor, der zum gasdichten Schliessen des Ventils auf den Ventilteller gedrückt wird. Derartige Ventile mit relativ zum Ventilteller aktiv verschiebbaren Ventilringen sind beispielsweise aus der DE 1 264 191 B1, der DE 34 47 008 C2, der US 3,145,969 (von Zweck) und der DE 77 31 993 U bekannt. In der US 5,577,707 (Brida) wird ein Pendelventil mit einem eine Öffnung aufweisenden Ventilgehäuse und einem parallel über die Öffnung schwenkbaren Ventilteller zum Steuern eines Durchflusses durch die Öffnung beschrieben. Ein Ventilring, der die Öffnung umschliesst, ist senkrecht in Richtung zum Ventilteller mittels mehrerer Federn und Druckluftzylinder aktiv bewegbar. Eine mögliche Weiterentwicklung dieses Pendelventils wird in der US 2005/0067603 A1 (Lucas et al.) vorgeschlagen.

Da oben genannte Ventile unter anderem bei der Herstellung hochsensibler Halbleiterelemente in einer Vakuumkammer zum Einsatz kommen, muss eine entsprechende Abdichtwirkung auch für solche Prozesskammern verlässlich gewährleistet sein. Hierfür ist insbesondere der Zustand eines Dichtmaterials oder einer bei Verpressung mit dem Dichtmaterial in Kontakt stehenden Dichtfläche von Bedeutung. Im Verlauf der Betriebsdauer eines Vakuumventils können typischerweise Abnutzungen des Dichtmaterials oder der Dichtflächen auftreten.

Um eine dabei eventuell entstehende Undichtigkeit zu vermeiden oder die Qualität der Dichtung auf einem konstant ausreichend hohen Niveau zu halten, wird ein Ventilverschluss typischerweise in bestimmten zeitlichen Abständen ausgetauscht bzw. erneuert. Ein solcher Wartungszyklus bemisst sich dabei meist an der Anzahl der zu erwartenden Öffnungs- und Schliesszyklen in einem bestimmten Zeitraum. Die Wartung erfolgt also meist vorsorglich um das Eintreten einer Undichtigkeit vorab weitestgehend ausschliessen zu können.

Ein solches Instandhaltungserfordernis beschränkt sich nicht allein auf das Dichtmaterial oder den Ventilteller, sondern erstreckt sich insbesondere ebenso auf den Ventilsitz, der einen zum Ventilteller korrespondierenden Teil des Vakuumventils bildet. Die Struktur einer Dichtfläche seitens des Ventilsitzes, z.B. einer in den Ventilsitz eingelassenen Nut, ist von einer mechanischen Beanspruchung ebenso betroffen. Daher kann auch eine aus einem Betrieb des Ventils resultiere strukturelle Veränderung der Nut eine Beeinträchtigung der Dichtung bewirken. Auch hierfür sind üblicherweise entsprechende Wartungsintervalle definiert.

Ein Nachteil dieser Ventilwartung liegt in deren vorsorglichem Charakter. Die von der Wartung betroffenen Teile werden zumeist vor Ablauf deren regulärer oder tatsächlicher Lebensdauer erneuert oder ersetzt. Jeder derartige Wartungsschritt bedeutet in der Regel eine gewisse Stillstandszeit für einen Produktionsprozess und einen erhöhnten technischen und finanziellen Aufwand. Dies bedeutet dann in Summe einen Stillstand der Produktion in Abständen, die kürzer sind als erforderlich, und häufiger als dies überhaupt notwendig wäre.

Der Erfindung liegt somit die Aufgabe zugrunde, ein verbessertes Vakuumventilsystem bereitzustellen, welches eine optimierte Ventilwartung und damit eine Verbesserung, d.h. Verkürzung von allfälligen Prozessstillständen, erlaubt.

Eine weitere Aufgabe der Erfindung ist es ein solches Ventilsystem bereitzustellen, mit dem eine zuverlässigere gasdichte Abdichtung eines Prozessvolumens erreicht werden kann, insbesondere wobei die Qualität der Abdichtung prognostizierbar ist.

Diese Aufgaben werden durch die Verwirklichung der kennzeichnenden Merkmale des unabhängigen Anspruchs gelöst. Merkmale, die die Erfindung in alternativer oder vorteilhafter Weise weiterbilden, sind den abhängigen Patentansprüchen zu entnehmen.

Die grundlegende Idee der vorliegenden Erfindung ist es ein Vakuumventil mit einem optischen Sensor zu kombinieren und das Ventil und den optischen Sensor dabei so auszugestalten, dass damit eine Überwachung einer der Dichtflächen des Vakuumventils erfolgen kann. Mit dem Sensor können sodann optische Messsignale von der Dichtfläche oder einem Dichtmaterial erfasst werden und anhand dieser Signale eine Zustandsinformation für den erfassten Bereich abgeleitet werden.

Hierdurch wird also eine Information über den Dichtflächenzustand zugänglich. Eine allfällige Veränderung, sei es bezüglich der chemischen Zusammensetzung oder der strukturellen Ausgestaltung der Dichtfläche (Dichtmaterial), kann somit überwacht und fortlaufend bewertet werden. Mittels der so erzeugbaren Daten kann ein Wartungs- bzw. Austauschzeitpunkt für die Dichtfläche bestimmt werden. Beispielsweise kann dadurch ein Versagen der Dichtigkeit des Ventils weitgehend vorhergesagt und eine (zeitlich) punktuell abgestimmte Gegenmassnahme eingeleitet werden. Wartungsintervalle sind dadurch besser planbar und effizienter durchführbar, wobei gleichzeitig die Prozessintegrität gewahrt und gesichert bleibt.

Als relevante Zustandsinformation für die Dichtfläche oder ein elastomeres Dichtmaterial kann z.B. ein Oberflächenverhalten (Verpressbarkeit), eine Farbe (z.B. des Dichtmaterials), eine chemische Zusammensetzung, eine Form und/oder eine Verschmutzung im Messbereich dienen.

Die Erfindung betrifft ein Vakuumventilsystem mit einem Vakuumventil zur Regelung eines Volumen- oder Massenstroms und/oder zum gasdichten Abschluss eines Prozessvolumens, wobei das Vakuumventil einen Ventilsitz aufweist, der eine eine Öffnungsachse definierende Ventilöffnung umläuft, und einen Ventilverschluss, insbesondere Ventilteller, zum im Wesentlichen gasdichten Verschliessen der Ventilöffnung aufweist.

Der Ventilsitz kann hierbei integraler Bestandteil des Vakuumventils sein und insbesondere einen Teil des Ventilgehäuses verkörpern. Alternativ kann der Ventilsitz durch die Öffnung einer Vakuumkammer gebildet sein und unter Zusammenwirkung mit einem relativ zu dem Ventilsitz beweglichen Ventilverschluss ein Vakuumventil im Sinne der vorliegenden Erfindung bilden.

Das Vakuumventil weist zudem mindestens zwei Dichtflächen auf, wobei eine erste Dichtfläche der mindestens zwei Dichtflächen von dem Ventilsitz bereitgestellt ist und die Ventilöffnung umläuft und eine zweite Dichtfläche der mindestens zwei Dichtflächen von dem Ventilverschluss bereitgestellt ist und mit der ersten Dichtfläche korrespondierend ausgebildet ist.

Insbesondere weist eine der beiden Dichtflächen ein Dichtmaterial auf. Das Dichtmaterial kann z.B. ein polymerbasiertes Material (z.B. Elastomer, insbesondere Fluorelastomer) sein, das auf die Dichtfläche aufvulkanisiert ist oder als O-Ring in einer Nut in dem Ventilverschluss oder dem Ventilsitz vorliegt. Als Dichtflächen werden im Rahmen der Erfindung also vorzugsweise diejenigen Flächen betrachtet, zwischen denen zum Verschliessen der Ventilöffnung (Schliessposition) ein Dichtmaterial verpresst vorliegt.

Mit dem Ventilverschluss ist eine Antriebseinheit gekoppelt, die derart ausgebildet ist, dass der Ventilverschluss zur Bereitstellung von jeweiligen Ventilöffnungszuständen, die durch jeweilige Positionen des Ventilverschlusses definiert sind, definiert variierbar und einstellbar ist. Der Ventilverschluss ist von einer Offenposition, in welcher der Ventilverschluss die Ventilöffnung zumindest teilweise freigibt in eine Schliessposition, in welcher die zweite Dichtfläche in Richtung der ersten Dichtfläche gedrückt wird und die Ventilöffnung im Wesentlichen gasdicht verschlossen ist, und zurück verstellbar.

Die Antriebseinheit ist beispielsweise als ein Elektromotor (Schrittmotor) oder als eine Kombination von mehreren Motoren oder als pneumatischer Antrieb ausgebildet. Insbesondere stellt der Antrieb eine Bewegung des Ventilverschlusses in zumindest zwei (im Wesentlichen orthogonale) Richtungen bereit.

Das Vakuumventilsystem weist zudem eine optische Sensoreinheit auf, wobei die optische Sensoreinheit zur Erfassung eines optischen Messsignals ausgebildet ist. Die Sensoreinheit ist derart angeordnet und eine optische Erfassungsachse (bzw. ein durch die Erfassungsachse definierter Erfassungsbereich) der optischen Sensoreinheit ist derart ausgerichtet, dass das Messsignal mit Bezug zu zumindest einem Teil einer der Dichtflächen erfassbar ist. Das Messsignal ist in einer Prüfstellung des Ventilverschlusses erzeugbar. Die Prüfstellung entspricht hierbei insbesondere der Offenposition, einer Zwischenposition oder der Schliessposition des Ventilverschlusses.

Die Erfassungsachse, z.B. eine optische Achse einer Kamera der Sensoreinheit, ist vorzugsweise in Richtung einer der zu prüfenden Dichtflächen ausgerichtet, so dass zumindest ein Teil der Dichtfläche in einem Erfassungsbereich (field of view) der Kamera liegt und ein Bild dieses Teils erfasst werden kann.

Gemäss einer Ausführungsform ist das Messsignal mit Bezug zu zumindest einem Teil einer der Dichtflächen nur in einer bestimmten Prüfstellung des Ventilverschlusses erzeugbar. So können die Erfassungsachse und das Ventil z.B. so ausgestaltet sein, dass die Dichtfläche des Ventilverschlusses nur in der geöffneten Ventilstellung in dem Erfassungsbereich um die Erfassungsachse vorliegt. So kann beispielsweise bei jedem Öffnen des Ventils eine aktuelle Zustandsaufnahme durchgeführt und so die aktuelle Qualität der Dichtfläche festgestellt werden.

Insbesondere definiert das Vakuumventil einen von einer äusseren Umgebung abgetrennten Vakuumbereich, z.B. den geometrischen Bereich innerhalb einer Vakuumkammer.

In einer Ausführungsform der Erfindung kann die optische Sensoreinheit zumindest teilweise innerhalb des Vakuumbereichs angeordnet sein und die Erfassungsachse in Richtung des Ventilsitzes zur Erfassung des optischen Messsignals für die zweite Dichtfläche ausgerichtet sein. Mittels einer solchen Anordnung wird es insbesondere vorteilhaft möglich, die Dichtfläche eines innen liegenden (in einem Prozessvolumen) Ventilsitzes zu überprüfen. Die Sensoreinheit kann hierfür z.B. in einer integrierten, kompakten Bauweise ausgeführt und bündig an einer Kammerwand angeordnet sein.

Ferner kann das Vakuumventilsystem ein zumindest für das optische Messsignal durchlässiges Transmissionsfenster aufweisen. Mittels des Transmissionsfensters kann eine Messstrahlung, die von der Sensoreinheit emittiert und/oder empfangen werden soll, aus dem Vakuumbereich in die äussere Umgebung und umgekehrt transmittiert werden. So lässt sich mit einem ausserhalb des Vakuumbereichs angeordneten Detektor ein Signal für eine in dem Vakuumbereich befindliche Dichtfläche empfangen und eine entsprechende Information unter Beibehaltung des Vakuums erzeugen. Vorteilhaft ist hierbei insbesondere, dass z.B. eine Energieversorgung für den Detektor und der Detektor selbst nicht in den Vakuumbereich gebracht werden müssen und damit ein vergleichsweise geringer konstruktiver Aufwand gewährleistet werden kann.

In anderen Worten ausgedrückt, kann die optische Sensoreinheit in der äusseren Umgebung derart angeordnet sein, dass das optische Messsignal via das Transmissionsfenster mit der optischen Sensoreinheit erfassbar ist, insbesondere wobei die Erfassungsachse der Sensoreinheit innerhalb des Transmissionsfensters liegt, sich also durch das Transmissionsfenster erstreckt.

Gemäss einer bestimmten Ausführungsform der Erfindung kann das Transmissionsfenster zumindest einen Teil einer der mindestens zwei Dichtflächen bilden. Ist das Fenster beispielsweise als Teil der zweiten Dichtfläche vorgesehen und weist die zweite Dichtfläche ein Dichtmaterial auf, so kann eine Information mit Bezug zur Rückseite des Dichtmaterials erzeugt werden. Mittels des so angeordneten Transmissionsfensters wird ein Interface oder eine Grenzschicht zwischen Dichtmaterial und Untergrund zugänglich. Hierdurch kann z.B. ein Zustand eines Haftverbunds zwischen dem Dichtmaterial und dem das Dichtmaterial tragenden Untergrund überprüft werden.

Die optische Sensoreinheit kann eine optische Faser zur Erfassung und Führung des optischen Messsignals aufweisen. Alternativ kann hierfür ein optischer Pfad in einer Freistrahloptik gebildet sein. Die optische Faser kann sich beispielsweise in den Ventilverschluss erstrecken und mit der Haftfläche für ein Dichtmaterial auf dem Ventilverschluss gekoppelt sein. Die Faser kann sich ebenso durch eine Kammerwand einer Vakuumkammer erstrecken und damit eine Messung in dem Kammerinnenraum ermöglichen.

So kann z.B. zumindest ein Teil der optischen Faser, insbesondere ein Faserende (mit Ferrule), in dem Vakuumbereich vorliegen und zur Erfassung des optischen Messsignals für zumindest eine der mindestens zwei Dichtflächen angeordnet und ausgerichtet sein.

Die optische Sensoreinheit kann auch mittels der Faser oder in Freistrahloptik mit dem Ventilverschluss verbunden sein, insbesondere wobei die Sensoreinheit, z.B. eine optische Faser der Sensoreinheit, zumindest teilweise in den Ventilverschluss integriert ist.

In einer Ausführungsform kann die optische Sensoreinheit ein Strahlerfassungsmodul aufweisen, wobei das Strahlerfassungsmodul über eine Kamera, einen Infrarot-Detektor, insbesondere Nahinfrarot-Detektor, insbesondere NIR-Spektrometer, einen Streulichtsensor und/oder einen Raman-Detektor verfügt. Es sind also unterschiedliche Sensoriken mit entsprechend unterschiedlichen chemischen, strukturellen oder bildbasierten Analysemöglichkeiten denkbar. Beispielsweise kann mittels einer optischen Erfassung einer Dichtfläche eine Rauheitsanalyse durchgeführt werden oder spektroskopisch eine chemische Analyse erfolgen.

Alternativ oder zusätzlich kann die Sensoreinheit z.B. einen Zeilensensor aufweisen. Dies kann insbesondere für die Erfassung einer entsprechend geformten Dichtfläche von Vorteil sein. Die Erfassung kann hierdurch schneller über den gesamten zu erfassenden Bereich erfolgen.

Gemäss der Erfindung kann das Vakuumventilsystem eine derart ausgebildete Verarbeitungseinheit aufweisen, dass ein erfasstes Messsignal mittels der Verarbeitungseinheit verarbeitbar ist und anhand des erfassten Messsignals eine Zustandsinformation erzeugbar ist. Die erfassten Messsignale können für die Bereitstellung einer bewertbaren Benutzerinformation weiterverarbeitet werden.

Die Zustandsinformation kann insbesondere eine Information bezüglich einer mechanischen und/oder strukturellen Integrität der ersten oder zweiten Dichtfläche bereitstellen. So kann beispielsweise anhand eines Bildes von einem Teil einer Dichtfläche eine Bewertung erfolgen, ob mit der in dem Bild erkennbaren Struktur der Dichtfläche eine geforderte Dichtwirkung zu erreichen sein wird. Insbesondere können allfällige Verschmutzungen oder Beschädigungen der Dichtfläche erkannt werden.

Die Zustandsinformation kann also mittels einer Bildverarbeitung und/oder mittels eines Ist-Soll-Vergleichs für das erfasste Messsignal erzeugt sein. Basis bildet dabei vorzugsweise ein aktuell erfasstes visuelles Bild der Dichtfläche und insbesondere ein Vergleichsbild für den erfassten Bereich, das einen Sollzustand der Dichtfläche als Referenz darstellt.

Basierend auf der Zustandsinformation kann ferner eine Materialzusammensetzung und/oder Änderung der Materialzusammensetzung für zumindest den erfassbaren Teil einer der mindestens zwei Dichtflächen ableitbar sein. Dies ist insbesondere dann der Fall, wenn ein Detektor (Strahlerfassungsmodul) der Sensoreinheit als chemisches Analysemodul (z.B. IR-Spektrometer) ausgebildet ist und die Zustandsinformation eine spektral aufgelöste Intensitätsverteilung für den erfassten Dichtflächenbereich bereitstellt.

Unter Heranziehung eines entsprechenden Referenzspektrums und mittels eines Vergleichs mit dem Referenzspektrum können Veränderungen in der chemischen Struktur z.B. des Dichtmaterials effizient festgestellt werden. Auf dieser Basis kann auch eine Bewertung einer Alterung und eine damit verbundene Qualitätsminderung des Dichtmaterials festgestellt werden. Alternativ oder zusätzlich kann auch direkt aus einem aktuell erzeugten Spektrum auf eine chemische Komposition des untersuchten Elements oder Materials geschlossen werden.

Erfindungsgemäss kann die Zustandsinformation als eine visuelle Repräsentation zumindest des erfassbaren Teils einer der mindestens zwei Dichtflächen, insbesondere als ein Bild zumindest des erfassbaren Teils der Dichtfläche, bereitgestellt werden.

Alternativ oder zusätzlich kann die Zustandsinformation als ein spektroskopische Messsignale verkörperndes Diagramm, insbesondere eine Wellenlängen-Intensitäts-Kurve, erzeugt sein. Dies trifft insbesondere dann zu, wenn die Sensoreinheit ein entsprechendes chemisches Analysemodul aufweist.

Ferner kann die Zustandsinformation als ein Ausgabesignal, das eine Relation des erfassten Messsignals zu einem bestimmten Toleranzwerte angibt, erzeugt werden. Durch ein solches (optisches oder akustisches) Signal kann z.B. angezeigt werden, ob ein Prozess innerhalb der geforderten Toleranzen abläuft oder ein unerwünschtes Unter- oder Überschreiten einer solchen Toleranz (z.B. Druckniveau) zu erwarten ist.

Der Ventilsitz des Vakuumventils kann durch einen strukturell mit dem Vakuumventil verbunden Teil des Vakuumventils gebildet sein, insbesondere wobei der Ventilsitz an einem Gehäuse des Vakuumventils ausgebildet ist, oder kann von einer Prozesskammer, insbesondere einem Kammergehäuse, bereitgestellt ist.

Es versteht sich, dass das Vakuumventil und die Sensoreinheit in einer integrierten Bauweise ausgeführt sein können und dieses System als ein entsprechend spezifisches Vakuumventil angesehen werden kann.

Die erfindungsgemässe Vorrichtung und das erfindungsgemässe Verfahren werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1: eine mögliche Ausführungsform eines erfindungsgemässen Vakuumventilsystems mit einem Pendelventil im Querschnitt dargestellt;
- Fig. 2a-d: verschiedene Ausführungsformen eines Vakuumventilsystems mit einem Transferventil in unterschiedlichen Verschlusspositionen; und
- Fig. 3: eine weitere Ausführungsform eines erfindungsgemässen Ventilsystems mit einem Transferventil und einer Sensoreinheit.

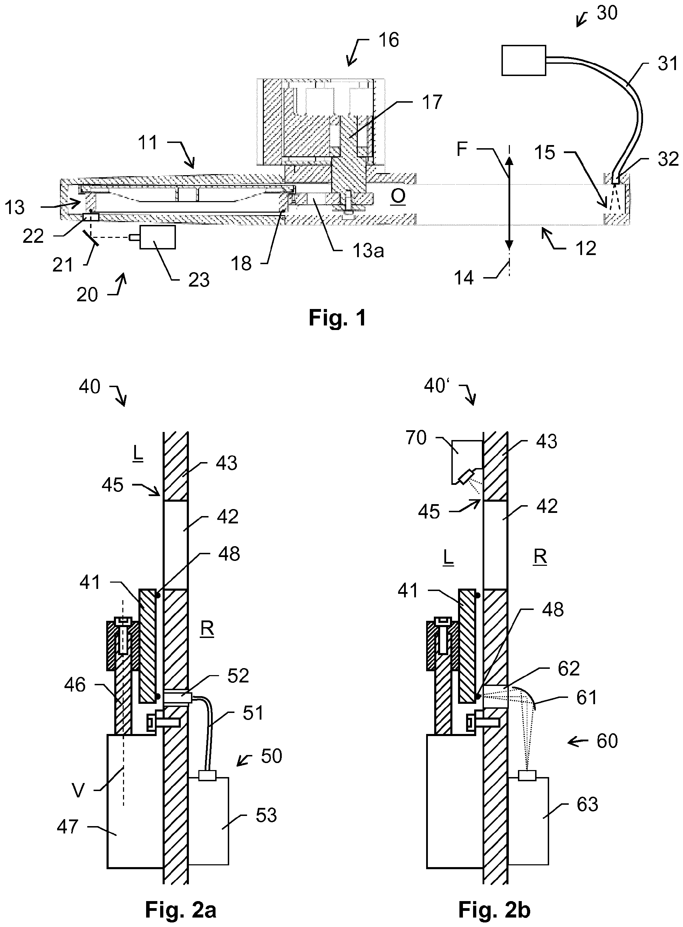

In Figur 1 ist eine mögliche Ausführungsform eines erfindungsgemässen Ventilsystems mit einem Pendelventil im Querschnitt dargestellt. Das Ventil zum im Wesentlichen gasdichten Unterbrechen eines Fliesswegs F besitzt ein Ventilgehäuse 11, welches eine Öffnung 12 aufweist. Die Öffnung 12 hat hier einen kreisrunden Querschnitt. In einer Geschlossenstellung eines Ventilverschlusses 13

(Ventilteller), ist die Öffnung 12 mittels des Ventiltellers 13 gasdicht verschlossen. Gezeigt ist hier das Ventil in einer Offenstellung O des Ventiltellers 13.

Die Öffnung 12 wird von einem Ventilsitz umschlossen. Dieser Ventilsitz wird von einer axial in Richtung des Ventiltellers 13 (in der Geschlossenstellung) weisenden und quer zur Öffnungsachse 14 verlaufenden, hier die Form eines Kreisrings aufweisenden, Dichtfläche 15, welche im Ventilgehäuse 11 ausgeformt ist, gebildet.

Ausserdem besitzt das Ventil einen schwenkbaren und zudem im Wesentlichen parallel zur Öffnungsachse 14 und in Richtung der Öffnungsachse 14 verstellbaren Ventilteller 13.

Der Ventilteller 13 ist über einen seitlich an dem Teller angeordneten, sich senkrecht zur Öffnungsachse 14 erstreckenden Arm 13a mit einem elektrischen Antrieb 16 (Motor) verbunden. Dieser Arm 13a befindet sich in der Geschlossenstellung des Ventiltellers 13 ausserhalb des entlang der Öffnungsachse 14 geometrisch projizierten Öffnungsquerschnitts der Öffnung 12.

Der elektrische Antrieb 16 ist durch Einsatz eines entsprechenden Getriebes derart ausgebildet, dass der Ventilteller 13 - wie bei einem Pendelventil üblich - mittels einer Querbewegung des Antriebs 16 quer zur Öffnungsachse 14 und im Wesentlichen parallel über den Querschnitt der Öffnung 12 und senkrecht zur Öffnungsachse 14 in Form einer Schwenkbewegung um eine Schwenkachse 17 zwischen einer Offenstellung O und einer Zwischenstellung schwenkbar und mittels einer parallel in Richtung der Öffnungsachse 14 erfolgenden Längsbewegung des Antriebs 16 linear verschiebbar ist. In der Offenstellung O, ist der Ventilteller 13 in einem seitlich neben der ersten Öffnung 12 angeordneten Verweilabschnitt positioniert, so dass die Öffnung 12 und der Fliessweg F freigegeben sind. In der Zwischenstellung ist der Ventilteller 13 über der ersten Öffnung 12 beabstandet positioniert und überdeckt den Öffnungsquerschnitt der Öffnung 12. In der Schliessposition ist die Öffnung 12 gasdicht geschlossen und der Fliessweg F unterbrochen, indem ein gasdichter Kontakt zwischen dem Ventilverschluss 13 (Ventilteller) und der Dichtfläche 15 des Ventilsitz besteht.

Um ein automatisiertes und geregeltes Öffnen und Schliessen des Ventils zu ermöglichen, kann das Ventil eine elektronische Regelung vorsehen, die derart ausgebildet ist und mit dem Antrieb 16 in derartiger Verbindung steht, dass der Ventilteller 13 zum gasdichten Abschliessen eines Prozessvolumens oder zum Regeln eines Innendrucks dieses Volumens entsprechend verstellbar ist.

Durch die Einstellung des Ventilverschlusses 13 wird ein jeweiliger Öffnungsquerschnitt für die Ventilöffnung 12 eingestellt und damit die mögliche Gasmenge eingestellt, die pro Zeiteinheit aus einem Prozessvolumen evakuiert werden kann. Der Ventilverschluss 13 kann zu diesem Zweck eine von einer kreisrunden Form abweichende Form aufweisen, insbesondere um einen möglichst laminaren Medienfluss zu erreichen.

Im vorliegenden Ausführungsbeispiel ist der Antrieb 16 als ein Elektromotor ausgebildet, wobei das Getriebe derart umschaltbar ist, dass ein Antreiben des Antriebs 16 entweder die Querbewegung oder die Längsbewegung bewirkt. Der Antrieb 16 und das Getriebe werden von der Regelung elektronisch angesteuert. Derartige Getriebe, insbesondere mit Kulissenschaltungen, sind aus dem Stand der Technik bekannt. Weiters ist es möglich, mehrere Antriebe zum Bewirken der Querbewegung und der Längsbewegung einzusetzen, wobei die Steuerung die Ansteuerung der Antriebe übernimmt.

Das präzise Regeln des Durchflusses mit dem beschriebene Pendelventil ist nicht nur durch das schwenkende Verstellen des Ventiltellers 13 zwischen der Offenstellung O und der Zwischenstellung mittels der Querbewegung, sondern vor allem durch lineares Verstellen des Ventiltellers 13 entlang der Öffnungsachse 14 zwischen der Zwischenstellung, der Geschlossenstellung mittels der Längsbewegung möglich. Das beschriebene Pendelventil kann für hochpräzise Regelaufgaben eingesetzt werden.

Neben dem Ventilsitz weist auch der Ventilteller 13 eine Dichtfläche 18 auf. Auf die Dichtfläche 18 des Ventiltellers 13 ist in der gezeigten Ausführungsform ein Dichtmaterial, z.B. ein Fluorpolymer, aufvulkanisiert. Das Dichtmaterial kann also z.B. als Polymer mittels Vulkanisation auf den Ventilsitz aufvulkanisiert sein. Alternativ kann die Dichtung z.B. als O-Ring in einer Nut des Ventilsitzes ausgeführt sein. Auch kann das Dichtmaterial auf den Ventilsitz aufgeklebt sein und dadurch die Dichtung verkörpern. In einer alternativen Ausführungsform kann die Dichtung seitens des Ventiltellers 38, insbesondere auf der Dichtfläche 15, angeordnet sein. Auch Kombinationen dieser Ausführungen sind denkbar.

Die Dichtfläche 18 ist in ihrer Form und Dimensionierung korrespondierend zur Dichtfläche 15 des Ventilsitzes angelegt. In der geschlossenen Position des Ventils ist die Dichtfläche 18 des Ventiltellers 13 auf die Dichtfläche 15 des Ventilsitzes gedrückt, wobei eine gewünschte Dichtwirkung (insbesondere gasdicht) mittels des dazwischen verpressten Dichtmaterials bereitgestellt ist.

Ein kritischer Faktor hinsichtlich einer typischerweise zu gewährleistenden Verlässlichkeit eines mit dem Pendelventil geregelten Bearbeitungsprozesses (z.B. in einer Vakuumkammer) ist eine eventuelle Abnutzung einer der Dichtflächen oder des Dichtmaterials selbst. Um einer allfälligen Prozessbeeinträchtigung vorzubeugen, werden die Dichtflächen bislang in regelmässigen Abständen vorsorglich gewartet bzw. ausgetauscht. Mit der vorliegenden Erfindung wird ermöglicht einen aktuellen Zustand zumindest einer der Dichtflächen (und zumindest teilweise für diese Dichtfläche) zu erfassen und zustandsabhängig eine Aktion, z.B. Instandhaltung, einzuleiten. Wartungsphasen oder - zeitpunkte können hierdurch zeitoptimiert geplant und durchgeführt werden.

Erfindungsgemäss wird hierfür zumindest eine Sensoreinheit vorgesehen, um einen Zustand einer Dichtfläche zu erfassen.

In der Ausführung nach Figur 1 sind zwei solcher Sensoreinheiten gezeigt. Es versteht sich jedoch, dass die Erfindung sich auf Ausführungsformen mit einer einzelnen Sensoreinheit ebenso erstreckt. Eine Kombination aus (mindestens) einer Sensoreinheit und einem Vakuumventil wie beschrieben bildet ein Vakuumventilsystem gemäss der Erfindung.

Das Vakuumventilsystem gemäss Figur 1 weist eine erste Sensoreinheit 20 auf. Die Sensoreinheit 20 ist ausserhalb des Ventilgehäuses 11 vorgesehen. Das Ventilgehäuse 11 weist ein erstes Fenster 22 auf, welches so ausgeführt ist, dass Messstrahlung, die entweder von der Sensoreinheit 20 emittiert oder erfasst (oder beides) wird, durch das Fenster 22 transmittierbar ist. Zudem ist ein Strahlumlenkelement 21 (z.B. Spiegel oder Prisma) vorgesehen, mit dem die Messstrahlung hin zu und weg von einem bestimmten Messbereich führbar ist. Das Strahlumlenkelement 21 stellt hier eine Ausrichtung einer Erfassungsachse der Sensoreinheit 20 in Richtung des Messbereichs bereit.

Wie zu sehen ist das Durchtrittsfenster 22 so angeordnet, dass in einer Offenstellung O ein Messsignal mit Bezug zu der Dichtfläche 18 - und damit bezüglich eines Teils des Dichtmaterials - erhalten werden kann. Für das Ausführen einer entsprechenden Messung kann die Dichtfläche 18 auf das Fenster 22 gedrückt oder in einem bestimmten Abstand gehalten werden.

Die Sensoreinheit 20 weist ein Spektrometer 23 auf, welches eine Materialanalyse mittels infraroter Strahlung ermöglicht. Somit ist mit der Sensoreinheit 20 Infrarotstrahlung emittierbar, die mittels des Umlenkelements 21 durch das Fenster 22 auf die

Dichtfläche 18 ausrichtbar ist. Nach einer Wechselwirkung der emittierten Strahlung mit der Dichtfläche 18, insbesondere mit dem Dichtmaterial, wird die reflektierte Strahlung dann wiederum mit der Sensoreinheit 20 erfasst. Für Emission und Erfassung sind vorzugsweise zwei getrennte Kanäle oder optische Pfade vorgesehen.

Aus einer Bestimmung der emittierten Strahlung und der erfassten Strahlung (Spektren der beiden Strahlen) und einem diesbezüglichen Vergleich der Einzelspektren kann eine Information bzgl. der Materialzusammensetzung der Dichtfläche 18 bzw. des Dichtmaterials abgeleitet werden. Hiermit kann z.B. durch Vergleich mit einem Sollspektrum für das Dichtmaterial eine Aussage über den aktuellen Zustand des Materials (z.B. chemische Materialveränderung über einen bestimmten Zeitraum) abgeleitet werden.

Generell kann die Sensoreinheit 20 nach dem Prinzip eines (Nah-) Infrarotspekrometers aufgebaut sein.

Eine zweite Sensoreinheit 30 ist als Bilderfassungseinheit (z.B. CCD- oder CMOS-Kamera) ausgeführt. Eine mit der Sensoreinheit 30 verbundene optische Faser 31 durchdringt mit deren freiem Ende das Ventilgehäuse 11. Das freie Ende kann z.B. mittels einer Hülse 32 oder einer Ferule so in das Ventilgehäuse 11 eingebettet sein, dass eine bezüglich Position und Orientierung feste Platzierung des Faserendes gegeben ist.

In der gezeigten Variante ist die Faser 31 so ausgerichtet, dass eine Bilderfassungsachse, die massgeblich durch die Ausrichtung des Faserendes bestimmt ist, in Richtung der Dichtfläche 15 des Ventilsitzes ausgerichtet ist. In der Hülse 32 kann eine optische Baugruppe vorgesehen sein, um ein scharfes Abbild der Dichtfläche 15 erfassen zu können.

Die Sensoreinheit 30 ermöglicht also eine Zustandsbestimmung der Dichtfläche 15 in der gezeigten Offenstellung O bzw. in jeder Stellung, in der der Ventilteller 13 nicht die Öffnung 12 überdeckt und der dem Faserende gegenüberliegende Ventilsitz nicht verdeckt ist. Es kann demnach ein Bild eines Teils der Dichtfläche 15 aufgenommen werden und anhand dieses Bildes eine Zustandsinformation erzeugt werden. Z.B. kann das erfasste Bild mittels Bildverarbeitung analysiert und ggf. mit einem Referenzbild verglichen werden. Hierdurch können z.B. Materialrückstände (des Dichtmaterials) erkannt oder Abnutzungen der Dichtfläche 15 festgestellt werden. Jeder dieser Zustände kann eine potentielle Ursache für eine zunehmende Undichtigkeit oder Prozessunsicherheit darstellen.

Alternativ zu einem Pendelventil wie dargestellt kann das erfindungsgemässe Vakuumventilsystem mit einem anderen Vakuumventiltyp, z.B. einem Klappventil, Schieberventil oder einem sog. Butterfly-Regelventil, realisiert sein. Insbesondere ist das System mit Druckregelventilen zum Einsatz im Vakuumbereich ausgebildet. Ferner ist ebenso ein Pendelventil einsetzbar, dessen Verschluss nur in einer Richtung verstellt werden kann.

In den Figuren 2a-d sind verschiedene Ausführungsformen eines Vakuumventilsystems mit Transferventilen in unterschiedlichen Verschlusspositionen dargestellt. Die Ausführungsformen unterscheiden sich zum Teil lediglich bezüglich bestimmter Merkmale voneinander, weshalb die Figuren im Folgenden im Wesentlichen gemeinsam beschrieben werden und teilweise nur auf die Unterschiede der Ausführungsformen eingegangen wird. Auf bereits in vorangegangenen Figuren erläuterte Bezugszeichen und Merkmale wird nicht immer erneut eingegangen.

Das gezeigte Transferventil 40,40',40" ist eine Sonderform eines Schieberventils. Das Vakuumventil 40,40',40" hat ein rechteckiges, plattenförmiges Verschlusselement 41, das eine Verschlussfläche zum gasdichten Verschliessen einer Öffnung 42 aufweist. Die Öffnung 42 hat einen dem Verschlusselement 41 entsprechenden Querschnitt und ist in einer Wand 43 ausgeformt. Die Öffnung 42 ist von einem Ventilsitz, der eine erste Dichtfläche 45 bereitstellt, umgeben.

Die Öffnung 42 verbindet einen ersten Gasbereich L, welcher sich links der Wand 43 befindet, mit einem zweiten Gasbereich R rechts der Wand 43. Die Wand 43 wird z.B. durch eine Kammerwand einer Vakuumkammer gebildet. Das Vakuumventil 40,40',40" wird dann durch ein Zusammenwirken der Kammerwand 43 mit dem Verschlusselement 41 gebildet.

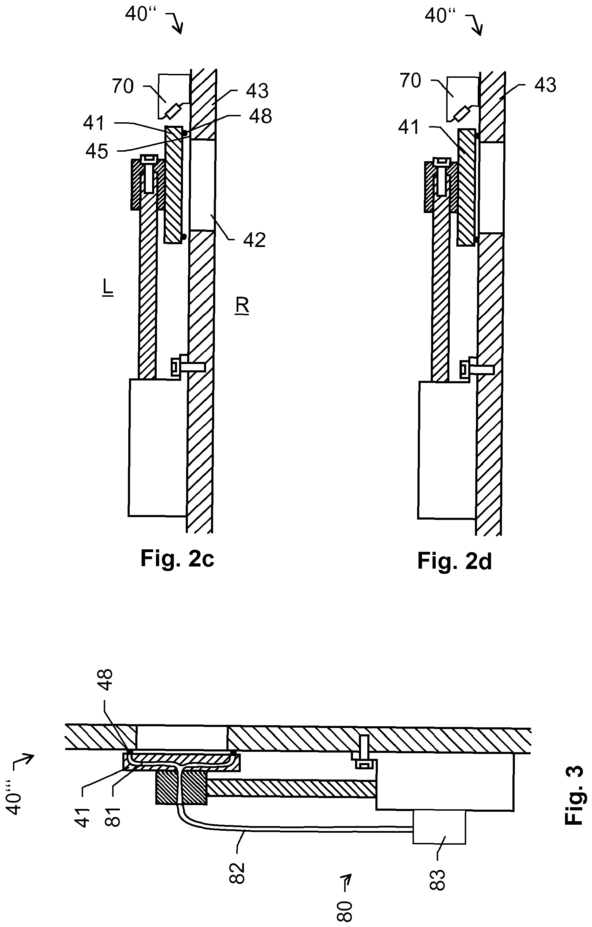

Das Verschlusselement 41 ist an einem Verstellarm 46 angeordnet, der stangenförmig ist und sich entlang einer geometrischen Verstellachse V erstreckt. Der Verstellarm 46 ist mit einer Antriebseinheit 47 mechanisch gekoppelt, mittels welcher das Verschlussglied 41 in dem ersten Gasbereich L links der Wand 43 durch Verstellen des Verstellarms 46 mittels der Antriebseinheit 47 zwischen einer Offenposition O, Figuren 2a und 2b, über eine Zwischenposition, Figur 2c, in eine Geschlossenposition, Figur 2d, verstellbar ist.

In der Offenposition O befindet sich das Verschlusselement 41 ausserhalb des Projektionsbereichs der Öffnung 42 und gibt diese vollständig frei, wie in Figur 2a gezeigt.

Durch Verstellen des Verstellarms 46 in axiale Richtung parallel zu der Verstellachse V und parallel zu der Wand 43 kann das Verschlusselement 41 mittels der Antriebseinheit 47 von der Offenposition O in die Zwischenposition verstellt werden.

In dieser Zwischenposition überdeckt die Verschlussfläche die Öffnung 42 und befindet sich in beabstandeter Gegenüberlage zu der die Öffnung 42 umgebenden Dichtfläche 45 des Ventilsitzes, wie in Figur 2c gezeigt.

Durch Verstellen des Verstellarms 46 in Richtung quer zu der Verstellachse V, also z.B. senkrecht zur Wand 43 und zum Ventilsitz, kann das Verschlusselement 41 von der Zwischenposition in die Geschlossenposition verstellt werden (Figur 2d).

In der Geschlossenposition verschliesst die Verschlussfläche des Verschlusselements 41 die Öffnung 42 gasdicht und trennt den ersten Gasbereich L von dem zweiten Gasbereich R gasdicht.

Das Öffnen und Schliessen des Vakuumventils 40,40',40" erfolgt also mittels der Antriebseinheit 47 durch eine L-förmige Bewegung des Verschlusselements 41 und des Verstellarms 46. Daher wird das gezeigte Transferventil auch L-Typ-Ventil genannt.

Das Verschlusselement 41 weist eine weitere Dichtfläche 48 auf, die mit der Dichtfläche 45 des Ventilsitzes korrespondiert. Die Dichtfläche 48 umläuft das Verschlusselement und trägt ein Dichtmaterial. In der Geschlossenposition wird die Dichtfläche 48 auf die Dichtfläche 45 gedrückt und das Dichtmaterial ist zwischen den beiden Dichtflächen 45 und 48 verpresst.

Ein Transferventil 40,40',40" wie gezeigt wird typischerweise zur Abdichtung eines Prozessvolumens (Vakuumkammer) und zur Be- und Entladung des Volumens vorgesehen. Häufige Wechsel zwischen der Offenposition und der Geschlossenposition sind bei einem solchen Einsatz die Regel. Hierdurch können verstärkte Abnutzungserscheinungen der Dichtflächen 45 und 48 eintreten. Zur Überwachung dieser Abnutzungen ist erfindungsgemäss zumindest eine Sensoreinheit vorgesehen. Eine Kombination aus einer solchen Sensoreinheit und einem Ventil 40,40',40" bildet ein Vakuumventilsystem gemäss der Erfindung.

Gemäss Figur 2a ist eine erste Sensoreinheit 50 mit einem Detektor 53, einer optischen Faser 51 und einer einen Transmissionskanal durch das Gehäuse 43 bereitstellenden optischen Komponente 52 vorgesehen, um den Zustand der Dichtfläche 48 erkennen zu können. Eine entsprechende Detektion ist mit der Sensoreinheit 50 in der Offenposition ermöglicht. Die optische Komponente 52 ist so mit dem Gehäuse verbunden bzw. darin ausgeformt, dass im Bereich der optischen Komponente 52 Gasdichtheit zwischen den Bereichen L und R besteht.

Ein Teil der Dichtfläche 48 befindet sich in der Offenstellung in einer Gegenüberlage zu der optischen Komponente 52 und Messstrahlung kann via die optische Komponente 52 und die optische Faser 51 mittels des Detektors 53 erfasst werden. Mit einer solchen Anordnung kann regelmässig, z.B. bei jedem erneuten Einnehmen der Offenstellung, die Dichtfläche 48 bzw. ein die Dichtfläche 48 repräsentierender Teilbereich analysiert und bezüglich Prozesssicherheit bewertet werden.

Beispielsweise können mit der Sensoreinheit 50 Variationen (Veränderungen) des Dichtmaterials über eine Prozessdauer hinweg beobachtet werden. Z.B. wird hier ein Oberflächenverhalten, die Farbe des erfassbaren Bereichs, eine chemische Zusammensetzung, die Form oder eine Verschmutzung festgestellt werden. Eine Veränderung bezüglich eines dieser Faktoren kann herangezogen werden, um eine Qualität der damit bereitstellbaren Dichtwirkung abzuleiten. Zudem ist damit eine allfällige Wartung oder eine Restlebensdauer vorhersehbar.

Welcher Art die Daten sind, die mit der Einheit 50 erzeugbar sind, ist massgebend durch die Ausführung des Detektors 51 bestimmt. Dieser kann beispielsweise als optische Kamera oder Spektrometer ausgebildet sein.

In der gezeigten Ausführung ist der Detektor 51 als IR-Spektrometer ausgeführt, wobei neben einem Erfassen von optischer Messstrahlung auch eine Emission infraroten Lichts in Richtung der Dichtfläche 48 bereitgestellt ist. Hierzu verfügt die optische Faser 51 über zwei räumlich getrennte Strahlengänge, ein Emissions- und ein Erfassungsstrahlengang.

Das Infrarotlicht kann hierbei auf das Dichtmaterial emittiert werden und dabei ein dem Dichtmaterial zugeordnetes Spektrum erfasst werden. Anhand des Spektrums (z.B. Lichtintensität über Wellenlänge) kann eine Materialzusammensetzung des Dichtmaterials abgeleitet und z.B. mit einer Referenz für die Materialzusammensetzung verglichen werden. Solch ein Vergleich kann kontinuierlich im Betrieb des Ventils vorgenommen und so eine Langzeitüberwachung der Dichtfläche 48 bereitgestellt werden. Hierdurch kann z.B. eine Alterung des Materials und ein dadurch zunehmende Sprödheit oder Porosität des Materials erkannt und auf dieser Basis ein angepasster Zeitpunkt für einen Austausch des Ventiltellers 41 oder der Dichtung bestimmt werden.

Es versteht sich, dass der Detektor 53 alternativ von der Wand 43 separiert angeordnet ist. Insbesondere kann der Detektor 53 thermisch und strukturell entkoppelt von der Ventileinheit vorliegen, wobei allein mittels einer entsprechend dimensionierten optischen Faser 51 (insbesondere Länge der Faser) die Erfassung der relevanten Messsignale bereitgestellt ist.

Figur 2b zeigt eine weitere Ausführungsform eines erfindungsgemässen Ventilsystems. Anstelle der Sensoreinheit 50 aus Figur 2a sind hier zwei Sensoreinheiten 60,70 anderer Ausführungen vorgesehen. Der Aufbau des Ventils 40' entspricht im Wesentlichen demjenigen Ventil 40 aus Figur 2a.

Der Detektor 61 der Sensoreinheit 60 ist als Nahinfrarotspektrometer zur chemischen Analyse der Dichtfläche 48 ausgebildet. Hierfür wird Messstrahlung mit einem definierten Spektrum im Infrarobereich (z.B. λ > 800 nm) emittiert und auf die Dichtfläche 48 gerichtet.

Für die Sensoreinheit 60 ist ein in die Wand 43 des Ventils integriertes Fenster 62 vorgesehen. Das Fenster 62 bildet im Verbund mit der Wand 43 eine gasdichte Trennung der Gasbereiche L und R. Die Öffnung 42 stellt eine verschliessbare Verbindung der Gasbereiche L und R bereit. Das Fenster 62 ist insbesondere so ausgebildet, dass sowohl die emittierte Messstrahlung als auch die nach einer Wechselwirkung mit der Dichtfläche seitens des Detektors 61 zu erfassende Messstrahlung durch das Fenster 61 nahezu verlustfrei transmittiert.

Zur Führung und gleichzeitigen Fokussierung der Messstrahlung auf das durch die Dichtfläche 48 bereitgestellte Dichtmaterial ist ein gekrümmter Umlenkspiegel 61 vorgesehen. So lässt sich eine Verbesserung des erhaltenen Messsignals erzielen, da hierdurch die Beleuchtung des Dichtmaterials intensiviert werden kann. Der Umlenkspiegel 61 schafft nicht nur eine Fokussierung in Richtung der Dichtfläche 48 sondern stellt auch ein entsprechendes Erfassen der Messstrahlung am Detektor 63 bereit.

Durch das Bestrahlen der Dichtfläche 48 bzw. des (polymerbasierten) Dichtmaterials werden bestimmte Energiezustände in den das jeweilige Material bildende Molekülen angeregt und dadurch Strahlung absorbiert. Die Absorption bzw. die Schwingungsanregung kann in einem dann erfassten Spektrum identifiziert werden. Daraus lässt sich ein Rückschluss auf die vorliegende Materialzusammensetzung ziehen.

Wie aus der Figur 2b ersichtlich kann eine entsprechende Analyse mit der Sensoreinheit 60 allein in der Offenstellung des Ventils 40' erfolgen. Es ist natürlich denkbar, dass mehrere derartige Sensoranordnungen über den Verlauf der Dichtfläche 48 hinweg angeordnet sind und damit eine Überprüfung an mehreren Stellen der Dichtfläche 48 erfolgen kann.

Zudem weist das Vakuumventilsystem nach Figur 2b eine weitere Sensoreinheit 70 auf. Die Sensoreinheit 70 ist in integrierter Bauweise ausgeführt und verfügt zumindest über einen Bilderfassungssensor und eine Optik. Die Sensoreinheit 70 ist derart an der Ventil- bzw.

Kammerwand 43 angeordnet, dass deren Bilderfassungsbereich (Field of View, FoV) auf die Dichtfläche 45 ausgerichtet ist und zumindest ein Teil der Dichtfläche 45 mittels der Sensoreinheit 70 bildhaft erfasst werden kann. Die Sensoreinheit 70 bzw. deren Gehäuse ist so konzipiert, dass Gasdichtheit gegenüber dem Gasvolumen L besteht.

Eine solche Sensoreinheit 70 kann z.B. innerhalb eines Vakuumvolumens angeordnet sein und damit eine Überwachung einer innenliegenden Dichtfläche erlauben. Der Gasbereich L ist dann dem Innenvolumen einer Vakuumprozesskammer gleichgesetzt.

Die Figur 2c zeigt eine weitere Ausführungsform eines erfindungsgemässen Ventilsystems, wobei das Schieberventil 40" hier in einer Zwischenstellung vorliegt. In der Zwischenstellung ist der Ventilteller 41 in einer Gegenüberlage zur Ventilöffnung 42 positioniert, wobei die Dichtflächen 45 und 48 sich nicht berühren.

Das Ventilsystem der Figur 2c weist ein Transferventil 40" und eine Sensoreinheit 70 auf. Die Sensoreinheit 70 ist - wie gemäss Figur 2b - vorgesehen, um eine Zustandsinformation für die wandseitige Dichtfläche 45 zu erzeugen. In der Zwischenposition ist es insbesondere noch möglich zumindest einen Teil des zu erfassenden Dichtflächenbereichs mit der Kameraeinheit 70 zu erfassen, da die Dichtfläche 45 nicht vollständig von dem Ventilteller 41 überdeckt ist. Hierdurch lässt sich also die Zustandsinformation erzeugen. Die Sensoreinheit 70 kann insbesondere als Zeilensensor zur angepassten Überwachung einer sich zumindest teilweise linear erstreckenden Dichtung ausgebildet sein.

In Figur 2d ist das Ventilsystem mit Ventil 40" und Sensor 70 in einer geschlossenen Positionierung des Ventiltellers 41 gezeigt. Die Dichtfläche 48 des Ventiltellers 41 ist hier auf die Dichtfläche 45 der Ventilwand 43 gedrückt. Die Dichtfläche 48 des Ventiltellers 41 ist somit von der Dichtfläche 45 der Ventilwand 43 überdeckt und nicht mehr für eine Bilderfassung mit der Einheit 70 zugänglich.

Figur 3 zeigt eine weitere Ausführungsform eines erfindungsgemässen Ventilsystems mit einem Transferventil 40'" und einer Sensoreinheit. Das Ventil 40'" selbst ist im Wesentlichen analog zu einem Ventil 40,40',40" aus einer der Figuren 2a-2d ausgeführt.

Der Unterschied zu den zuvor gezeigten Systemen liegt darin, dass in dieser Ausführung die Zustandsinformation basierend auf Messdaten erzeugbar ist, die aus Richtung der Rückseite der Dichtfläche 48 erfasst werden können. Hierzu weist der Ventilteller 41 einen inneren optischen Pfad 81 auf. Der optische Pfad 81 ist beispielsweise durch eine optische Faser verkörpert. Ein Ende der optischen Faser ist mit der Rückseite der Dichtfläche 48 gekoppelt. Die Dichtfläche 48 kann dabei insbesondere für die durch die optische Faser zu erfassende oder emittierende Messstrahlung durchlässig ausgeführt sein, z.B. als transparente Fensterfläche.

Der optische Pfad 81 ist mittels einer (weiteren) optischen Faser 82 mit dem Sensor 83 verbunden. Der Sensor 83 ist vorzugsweise als Kamera oder Zeilensensor ausgebildet, wobei Bilder von der Rückseite der Dichtfläche 48 erfasst werden können. Der optische Pfad 81 kann z.B. umlaufend entlang der Dichtfläche 48 bereitgestellt sein oder es ist zumindest ein Punkt an der Dichtflächenrückseite durch den optischen Pfad 81 zugänglich. Entsprechend sind die Bilder von der Rückseite erfassbar.

Durch einen Bildvergleich (Soll-Ist-Vergleich) kann dann ein aktueller Zustand der Dichtfläche 48, insbesondere des auf der Dichtfläche 48 aufgebrachten polymerbasierten Dichtmaterials, abgeleitet werden. So können z.B. Ablösungen des Dichtmaterials von der Dichtfläche 48 oder anderweitige Beeinträchtigung des Dichtverbundes festgestellt werden.

Es versteht sich, dass der Sensor 83 alternativ als Spektrometer mit einer Strahlquelle für die Messstrahlung und mit einem Detektor zur Erfassung der Messstrahlung nach Wechselwirkung mit der Dichtfläche 48 ausgebildet sein kann. Vorzugsweise sind dann für das Emittieren und für das Empfangen der Messstrahlung zwei getrennte optische Pfade vorgesehen, die mit einer spezifischen optischen Faser bereitgestellt sein können.

Es versteht sich, dass die dargestellten Figuren nur mögliche Ausführungsbeispiele schematisch darstellen. Die verschiedenen Ansätze können erfindungsgemäss ebenso miteinander sowie mit Vakuumventilen und Vakuumprozessen des Stands der Technik kombiniert werden.

## Patentansprüche

1. Vakuumventilsystem mit einem
Vakuumventil (40,40',40",40"') zur Regelung eines Volumen- oder Massenstroms und/oder zum gasdichten Abschluss eines Prozessvolumens, wobei das Vakuumventil (40,40',40",40"') aufweist
• einen Ventilsitz, der eine eine Öffnungsachse (14) definierende Ventilöffnung (12,42) umläuft,
• einen Ventilverschluss (13,41), insbesondere Ventilteller, zum im Wesentlichen gasdichten Verschliessen der Ventilöffnung (12,42) und
• mindestens zwei Dichtflächen (15,18,45,48), wobei
□ eine erste Dichtfläche (15,45) der mindestens zwei Dichtflächen von dem Ventilsitz bereitgestellt ist und die Ventilöffnung (12,42) umläuft und
□ eine zweite Dichtfläche (18,48) der mindestens zwei Dichtflächen von dem Ventilverschluss (13,41) bereitgestellt ist und mit der ersten Dichtfläche (15,45) korrespondierend ausgebildet ist,
• eine mit dem Ventilverschluss (13,41) gekoppelte Antriebseinheit (16), die derart ausgebildet ist, dass der Ventilverschluss (13,41)
□ zur Bereitstellung von jeweiligen Ventilöffnungszuständen definiert variierbar und einstellbar ist und
□ von einer Offenposition (O), in welcher der Ventilverschluss (13,41) die Ventilöffnung (12,42) zumindest teilweise freigibt in eine Schliessposition, in welcher die zweite Dichtfläche (18,48) in Richtung der ersten Dichtfläche (15,45) gedrückt wird und die Ventilöffnung (12,42) im Wesentlichen gasdicht verschlossen ist, und zurück verstellbar ist,
wobei das Vakuumventilsystem eine optische Sensoreinheit (20,30,50,60,70,80) aufweist, wobei die optische Sensoreinheit (20,30,50,60,70,80) zur Erfassung eines optischen Messsignals ausgebildet ist,
**dadurch gekennzeichnet, dass**
die optische Sensoreinheit (20,30,50,60,70,80) derart angeordnet und eine optische Erfassungsachse der optischen Sensoreinheit (20,30,50,60,70,80) derart ausgerichtet ist, dass das Messsignal mit Bezug zu zumindest einem Teil einer der Dichtflächen (15,18,45,48) erfassbar ist,
wobei das Messsignal in einer Prüfstellung des Ventilverschlusses (13,41) erzeugbar ist und anhand des Messsignals eine Zustandsinformation mit Bezug zu dem zumindest einen Teil einer der
Dichtflächen (15,18,45,48) bereitstellbar ist.

2. Vakuumventilsystem nach Anspruch 1,
**dadurch gekennzeichnet, dass**
das Messsignal mit Bezug zu zumindest einem Teil einer der Dichtflächen (15,18,45,48) nur in einer bestimmten Prüfstellung des Ventilverschlusses (13,41) erzeugbar ist.

3. Vakuumventilsystem nach Anspruch 1 oder 2,
**dadurch gekennzeichnet, dass**
das Vakuumventil (40,40',40",40"') einen von einer äusseren Umgebung abgetrennten Vakuumbereich definiert.

4. Vakuumventilsystem nach Anspruch 3,
**dadurch gekennzeichnet, dass**
• die optische Sensoreinheit (20,30,50,60,70,80) zumindest teilweise innerhalb des Vakuumbereichs angeordnet ist und
• die Erfassungsachse in Richtung des Ventilsitzes zur Erfassung des optischen Messsignals für die zweite Dichtfläche (18,48) ausgerichtet ist.

5. Vakuumventilsystem nach einem der Ansprüche 1 bis 4,
**dadurch gekennzeichnet, dass**
das Vakuumventil (40,40',40",40"') ein zumindest für das optische Messsignal durchlässiges Transmissionsfenster (22,62) aufweist.

6. Vakuumventilsystem nach Anspruch 5,
**dadurch gekennzeichnet, dass**
die optische Sensoreinheit (20,30,50,60,70,80) in der äusseren Umgebung derart angeordnet ist, dass das optische Messsignal via das
Transmissionsfenster (22,62) mit der optischen Sensoreinheit (20,30,50,60,70,80) erfassbar ist, insbesondere wobei die Erfassungsachse innerhalb des Transmissionsfensters (22,62) liegt.

7. Vakuumventilsystem nach Anspruch 5 oder 6,
**dadurch gekennzeichnet, dass**
das Transmissionsfenster (22,62) zumindest einen Teil einer der mindestens zwei Dichtflächen (15,18,45,48) bildet.

8. Vakuumventilsystem nach einem der Ansprüche 1 bis 7,
**dadurch gekennzeichnet, dass**
die optische Sensoreinheit (20,30,50,60,70,80) eine optische Faser (31,51,81,82) zur Erfassung und Führung des optischen Messsignals aufweist, insbesondere wobei zumindest ein Teil der optischen Faser (31,51,81,82), insbesondere ein Faserende, in dem Vakuumbereich vorliegt und zur Erfassung des optischen Messsignals für zumindest eine der mindestens zwei Dichtflächen (15,18,45,48) angeordnet und ausgerichtet ist.

9. Vakuumventilsystem nach einem der Ansprüche 1 bis 8,
**dadurch gekennzeichnet, dass**
die optische Sensoreinheit (20,30,50,60,70,80) mit dem Ventilverschluss (13,41) verbunden ist, insbesondere zumindest teilweise in den Ventilverschluss (13,41) integriert ist.

10. Vakuumventilsystem nach einem der Ansprüche 1 bis 9,
**dadurch gekennzeichnet, dass**
die optische Sensoreinheit (20,30,50,60,70,80) ein Strahlerfassungsmodul (23,53,63,83) aufweist mit
• einer Kamera,
• einem Infrarot-Detektor, insbesondere Nahinfrarot-Detektor, insbesondere NIR-Spektrometer,
• einem Streulichtsensor und/oder
• einem Raman-Detektor.

11. Vakuumventilsystem nach einem der Ansprüche 1 bis 10,
**dadurch gekennzeichnet, dass**
das Vakuumventilsystem eine derart ausgebildete Verarbeitungseinheit aufweist, dass ein erfasstes Messsignal mittels der Verarbeitungseinheit verarbeitbar ist und anhand des erfassten Messsignals die Zustandsinformation erzeugbar ist.

12. Vakuumventilsystem nach Anspruch 11,
**dadurch gekennzeichnet, dass**
• die Zustandsinformation eine Information bezüglich einer chemischen, mechanischen und/oder strukturellen Integrität der ersten oder zweiten Dichtfläche (15,18,45,48) bereitstellt
und/oder
• die Zustandsinformation mittels einer Bildverarbeitung und/oder mittels eines Ist-Soll-Vergleichs für das erfasste Messsignal erzeugt ist.

13. Vakuumventilsystem nach Anspruch 11 oder 12,
**dadurch gekennzeichnet, dass**
basierend auf der Zustandsinformation eine Materialzusammensetzung und/oder Änderung der Materialzusammensetzung für zumindest den erfassbaren Teil einer der mindestens zwei
Dichtflächen (15,18,45,48) ableitbar ist.

14. Vakuumventilsystem nach einem der Ansprüche 11 bis 13,
**dadurch gekennzeichnet, dass**
die Zustandsinformation als
• eine visuelle Repräsentation zumindest des erfassbaren Teils einer der mindestens zwei Dichtflächen (15,18,45,48), insbesondere als ein Bild zumindest des erfassbaren Teils der Dichtfläche (15,18,45,48), oder
• ein spektroskopische Messsignale verkörperndes Diagramm, insbesondere eine Wellenlängen-Intensitäts-Kurve, oder
• ein Ausgabesignal, das eine Relation des erfassten Messsignals zu einem bestimmten Toleranzwerte angibt, erzeugt ist.

15. Vakuumventilsystem nach einem der Ansprüche 1 bis 14,
**dadurch gekennzeichnet, dass**
der Ventilsitz
• durch einen strukturell mit dem Vakuumventil verbunden Teil des Vakuumventils gebildet wird, insbesondere wobei der Ventilsitz an einem Gehäuse des Vakuumventils ausgebildet ist, oder
• von einer Prozesskammer, insbesondere einem Kammergehäuse, bereitgestellt ist.

## Claims

1. Vacuum valve system having a vacuum valve (40, 40', 40", 40"') for regulating a volume or mass flow and/or for the gas-tight closure of a process volume, wherein the vacuum valve (40, 40', 40", 40'") has
• a valve seat which surrounds a valve opening (12, 42) defining an opening axis (14),
• a valve closure (13, 41), in particular a valve disk, for substantially gas-tight closing of the valve opening (12, 42) and
• at least two sealing surfaces (15, 18, 45, 48), wherein
o a first sealing surface (15, 45) of the at least two sealing surfaces is provided by the valve seat and surrounds the valve opening (12, 42) and
o a second sealing surface (18, 48) of the at least two sealing surfaces is provided by the valve closure (13, 41) and is formed to correspond with the first sealing surface (15, 45),
• a drive unit (16) which is coupled to the valve closure (13, 41) and is designed in such a way that the valve closure (13, 41)
∘ can be varied and adjusted in a defined manner to provide respective valve opening states, and
∘ is adjustable from an open position (O), in which the valve closure (13, 41) at least partially opens the valve opening (12, 42), to a closed position, in which the second sealing surface (18, 48) is pressed in the direction of the first sealing surface (15, 45) and the valve opening (12, 42) is closed in a substantially gas-tight manner, and back again, wherein the vacuum valve system has an optical sensor unit (20, 30, 50, 60, 70, 80), wherein the optical sensor unit (20, 30, 50, 60, 70, 80) is designed for detecting an optical measurement signal,
**characterized in that**
the optical sensor unit (20, 30, 50, 60, 70, 80) is arranged and an optical detection axis of the optical sensor unit (20, 30, 50, 60, 70, 80) is aligned such that the measurement signal is measured with respect to at least a part of one of the sealing surfaces (15, 18, 45, 48),
wherein the measurement signal can be generated in a test position of the valve closure (13, 41) and status information can be provided on the basis of the measurement signal with reference to the at least part of one of the sealing surfaces (15, 18, 45, 48).

2. Vacuum valve system according to claim 1, **characterized in that** the measurement signal can be generated with reference to at least a part of one of the sealing surfaces (15, 18, 45, 48) only in a specific test position of the valve closure (13, 41).

3. Vacuum valve system according to claim 1 or 2, **characterized in that** the vacuum valve (40, 40', 40", 40"') defines a vacuum region separated from an external environment.

4. Vacuum valve system according to claim 3, **characterized in that**
• the optical sensor unit (20, 30, 50, 60, 70, 80) is arranged at least partially within the vacuum region, and
• the detection axis is aligned in the direction of the valve seat for detecting the optical measurement signal for the second sealing surface (18, 48).

5. Vacuum valve system according to one of claims 1 to 4, **characterized in that** the vacuum valve (40, 40', 40", 40"') has a transmission window (22, 62) which is permeable at least to the optical measurement signal.

6. Vacuum valve system according to claim 5, **characterized in that** the optical sensor unit (20, 30, 50, 60, 70, 80) is arranged in the external environment in such a way that the optical measurement signal can be detected via the transmission window (22, 62) with the optical sensor unit (20, 30, 50, 60, 70, 80), in particular wherein the detection axis lies within the transmission window (22, 62).

7. Vacuum valve system according to claim 5 or 6, **characterized in that** the transmission window (22, 62) forms at least part of one of the at least two sealing surfaces (15, 18, 45, 48).

8. Vacuum valve system according to one of claims 1 to 7, **characterized in that** the optical sensor unit (20, 30, 50, 60, 70, 80) has an optical fiber (31, 51, 81, 82) for detecting and guiding the optical measurement signal, in particular wherein at least a part of the optical fiber (31, 51, 81, 82), in particular a fiber end, is present in the vacuum region and is arranged and aligned for detecting the optical measurement signal for at least one of the at least two sealing surfaces (15, 18, 45, 48).

9. Vacuum valve system according to one of claims 1 to 8, **characterized in that** the optical sensor unit (20, 30, 50, 60, 70, 80) is connected to the valve closure (13, 41), in particular is integrated at least partially in the valve closure (13, 41).

10. Vacuum valve system according to one of claims 1 to 9, **characterized in that** the optical sensor unit (20, 30, 50, 60, 70, 80) has a beam detection module (23, 53, 63, 83) having
• a camera,
• an infrared detector, in particular a near infrared detector, in particular an NIR spectrometer,
• a scattered light sensor and/or
• a Raman detector.

11. Vacuum valve system according to one of claims 1 to 10, **characterized in that** the vacuum valve system has a processing unit designed in such a way that a detected measurement signal can be processed by means of the processing unit and the status information can be generated on the basis of the detected measurement signal.

12. Vacuum valve system according to claim 11, **characterized in that**
• the status information provides information relating to a chemical, mechanical and/or structural integrity of the first or second sealing surface (15, 18, 45, 48),
and/or
• the status information is generated by means of image processing and/or by means of an actual/target value comparison for the acquired measurement signal.

13. Vacuum valve system according to claim 11 or 12, **characterized in that** a material composition and/or change in the material composition can be derived based on the status information for at least the detectable part of one of the at least two sealing surfaces (15, 18, 45, 48).

14. Vacuum valve system according to one of claims 11 to 13, **characterized in that** the status information is generated as
• a visual representation of at least the detectable part of one of the at least two sealing surfaces (15, 18, 45, 48), in particular as an image of at least the detectable part of the sealing surface (15, 18, 45, 48), or
• a diagram embodying a spectroscopic measurement signal, in particular a wavelength intensity curve, or
• an output signal indicating a relation of the detected measurement signal to a certain tolerance value.

15. Vacuum valve system according to one of claims 1 to 14, **characterized in that** the valve seat
• is formed by a part of the vacuum valve structurally connected to the vacuum valve, in particular wherein the valve seat is formed on a housing of the vacuum valve, or
• is provided by a process chamber, in particular a chamber housing.

## Revendications

1. Système de soupape à vide avec une soupape à vide (40, 40', 40", 40"') pour la régulation d'un débit volumétrique ou massique et/ou pour la fermeture étanche aux gaz d'un volume de process, dans lequel la soupape à vide (40, 40', 40", 40"') présente
• un siège de soupape qui entoure une ouverture de soupape (12, 14) définissant un axe d'ouverture (14),
• une fermeture de soupape (13, 41), en particulier un disque de soupape, pour la fermeture sensiblement étanche aux gaz de l'ouverture de soupape (12, 42) et
• au moins deux surfaces d'étanchéité (15, 18, 45, 48),
° une première surface d'étanchéité (15, 45) parmi les au moins deux surfaces d'étanchéité étant créée par le siège de soupape et entourant l'ouverture de soupape (12, 42) et
° une deuxième surface d'étanchéité (18, 48) parmi les au moins deux surfaces d'étanchéité étant créée par la fermeture de soupape (13, 41) et ayant une forme correspondant à la première surface d'étanchéité (15, 45),
• une unité d'entraînement (16) couplée à la fermeture de soupape (13, 41), conformée de telle manière que la fermeture de soupape (13, 41)
∘ puisse être déplacée et réglée de façon définie pour créer différents états d'ouverture de la soupape et
∘ puisse être déplacée d'une position ouverte (O) dans laquelle la fermeture de soupape (13, 41) dégage au moins en partie l'ouverture de soupape (12, 42) à une position de fermeture dans laquelle la deuxième surface d'étanchéité (18, 48) est poussée en direction de la première surface d'étanchéité (15, 45) et l'ouverture de soupape (12, 42) est fermée de façon sensiblement étanche aux gaz, et retour,
le système de soupape à vide présentant une unité de capteur optique (20, 30, 50, 60, 70, 80), laquelle unité de capteur optique (20, 30, 50, 60, 70, 80) est conçue pour capter un signal de mesure optique,
**caractérisé en ce que** l'unité de capteur optique (20, 30, 50, 60, 70, 80) est disposée de telle manière et un axe optique d'acquisition de l'unité de capteur optique (20, 30, 50, 60, 70, 80) est orienté de telle manière que le signal de mesure puisse être capté par rapport à au moins une partie de l'une des surfaces d'étanchéité (15, 18, 45, 48),
le signal de mesure pouvant être généré dans une position d'essai de la fermeture de soupape (13, 41) et une information d'état relative à au moins la partie de l'une des surfaces d'étanchéité (15, 18, 45, 48) pouvant être fournie à l'aide du signal de mesure.

2. Système de soupape à vide selon la revendication 1, **caractérisé en ce que** le signal de mesure ne peut être généré en relation avec au moins une partie de l'une des surfaces d'étanchéité (15, 18, 45, 48) que dans une certaine position d'essai de la fermeture de soupape (13, 41).

3. Système de soupape à vide selon la revendication 1 ou 2, **caractérisé en ce que** la soupape à vide (40, 40', 40", 40"') définit une zone de vide isolée de l'environnement extérieur.

4. Système de soupape à vide selon la revendication 3, **caractérisé en ce que**
• l'unité de capteur optique (20, 30, 50, 60, 70, 80) est disposée au moins en partie à l'intérieur de la zone de vide et
• l'axe d'acquisition est orienté dans la direction du siège de soupape pour l'acquisition du signal de mesure optique pour la deuxième surface d'étanchéité (18, 48).

5. Système de soupape à vide selon l'une des revendications 1 à 4, **caractérisé en ce que** la soupape à vide (40, 40', 40", 40"') présente une fenêtre de transmission (22, 62) qui laisse passer au moins le signal de mesure optique.

6. Système de soupape à vide selon la revendication 5, **caractérisé en ce que** l'unité de capteur optique (20, 30, 50, 60, 70, 80) est disposée dans l'environnement extérieur, de telle manière que le signal de mesure optique puisse être capté à travers la fenêtre de transmission optique (22, 62) avec l'unité de capteur optique (20, 30, 50, 60, 70, 80), l'axe d'acquisition se trouvant en particulier à l'intérieur de la fenêtre de transmission optique (22, 62).

7. Système de soupape à vide selon la revendication 5 ou 6, **caractérisé en ce que** la fenêtre de transmission optique (22, 62) forme au moins une partie de l'une des au moins deux surfaces d'étanchéité (15, 18, 45, 48).

8. Système de soupape à vide selon l'une des revendications 1 à 7, **caractérisé en ce que** l'unité de capteur optique (20, 30, 50, 60, 70, 80) comporte une fibre optique (31, 51, 81, 82) pour capter et guider le signal de mesure optique, de sorte qu'en particulier, au moins une partie de la fibre optique (31, 51, 81, 82), en particulier une extrémité de fibre, se situe dans la zone de vide et est disposée et orientée de façon à capter le signal de mesure optique pour au moins une des au moins deux surfaces d'étanchéité (15, 18, 45, 48).

9. Système de soupape à vide selon l'une des revendications 1 à 8, **caractérisé en ce que** l'unité de capteur optique (20, 30, 50, 60, 70, 80) est reliée à la fermeture de soupape (13, 41), en particulier au moins partiellement intégrée dans la fermeture de soupape (13, 41).

10. Système de soupape à vide selon l'une des revendications 1 à 9, **caractérisé en ce que** l'unité de capteur optique (20, 30, 50, 60, 70, 80) comprend un module d'acquisition de rayonnement (23, 53, 63, 83) avec
• une caméra,
• un détecteur d'infrarouges, en particulier un détecteur de proche infrarouge, en particulier un spectromètre NIR,
• un capteur de lumière dispersée et/ou
• un détecteur Raman.

11. Système de soupape à vide selon l'une des revendications 1 à 10, **caractérisé en ce qu'**il comporte une unité de traitement conçue de telle façon qu'un signal de mesure acquis puisse être traité au moyen de l'unité de traitement et que l'information d'état puisse être générée à partir du signal de mesure acquis.

12. Système de soupape à vide selon la revendication 11, **caractérisé en ce que**
• l'information d'état fournit une information concernant une intégrité chimique, mécanique et/ou structurelle de la première ou deuxième surface d'étanchéité (15, 18, 45, 48)
et/ou
• l'information d'état est générée au moyen d'un traitement d'image et/ou au moyen d'une comparaison entre valeur de consigne et valeur réelle du signal de mesure acquis.

13. Système de soupape à vide selon la revendication 11 ou 12, **caractérisé en ce que**, sur la base de l'information d'état, une composition de matériau et/ou un changement de matériau peut être déduit pour au moins la partie détectable des au moins deux surfaces d'étanchéité (15, 18, 45, 48).

14. Soupape à vide selon l'une des revendications 11 à 13, **caractérisé en ce que** l'information d'état est générée sous la forme
• d'une représentation visuelle au moins de la partie détectable de l'une des au moins deux surfaces d'étanchéité (15, 18, 45, 48), en particulier sous la forme d'une image de la partie détectable de la surface d'étanchéité (15, 18, 45, 48) au minimum, ou
• un diagramme figurant des signaux de mesures spectroscopiques, en particulier une courbe de longueurs d'onde et d'intensité, ou
• un signal de sortie indiquant une relation entre le signal de mesure acquis et une certaine valeur de tolérance.

15. Système de soupape à vide selon l'une des revendications 1 à 14, **caractérisé en ce que** le siège de soupape
• est formé par une partie structurellement reliée à la soupape à vide de la soupape à vide, en particulier par le fait que le siège de soupape est formé sur un corps de la soupape à vide, ou
• est créé par une chambre de process, en particulier un corps de chambre.
